# EUROPÄISCHE PATENTSCHRIFT

(11) **EP 3 084 841 B1**
(45) Veröffentlichungstag und Bekanntmachung des Hinweises auf die Patenterteilung: **16.03.2022**
(21) Anmeldenummer: 14821140.2
(22) Anmeldetag: 17.12.2014
(51) Int. Cl.: H01L 31/05

(54) **PHOTOVOLTAIKMODUL**
PHOTOVOLTAIC MODULE
MODULE PHOTOVOLTAÏQUE

(30) Priorität: 20.12.2013 DE 102013226943; 21.01.2014 DE 102014200956
(43) Veröffentlichungstag der Anmeldung: 26.10.2016
(73) Patentinhaber: Fraunhofer-Gesellschaft zur Förderung der angewandten Forschung e.V., 80686 München (DE)
(72) Erfinder: KUHN, Tilmann, 79856 Hinterzarten (DE); WILSON, Helen Rose, 79111 Freiburg (DE)
(74) Vertreter: Friese Goeden Patentanwälte PartGmbB
(86) Internationale Anmeldenummer: PCT/EP2014/078317
(87) Internationale Veröffentlichungsnummer: WO 2015/091698

(56) Entgegenhaltungen:
- EP-A1- 2 660 878
- US-A1- 2011 005 569
- US-A1- 2011 174 355
- US-A1- 2011 290 296
- US-A1- 2011 303 260
- US-A1- 2012 080 080
- US-A1- 2012 085 383
- US-A1- 2012 204 928

## Beschreibung

Die Erfindung betrifft eine photovoltaische Zelle, welche ein Halbleitersubstrat mit einer Vorderseite und einer Rückseite aufweist, wobei auf der Vorderseite zumindest ein Vorderseitenkontakt angeordnet ist und auf der Rückseite zumindest ein Rückseitenkontakt angeordnet ist. Weiterhin betrifft die Erfindung ein Photovoltaikmodul mit einer Mehrzahl photovoltaischer Zellen, ein Verfahren zur Herstellung einer photovoltaischen Zelle und ein Gebäude oder ein Fassadenelement mit einem solchen Photovoltaikmodul.

Aus der US 2012/0204928 A1 ist bekannt, photovoltaische Zellen aus Halbleitermaterial herzustellen. Die photovoltaische Zelle besteht im Wesentlichen aus einer flächigen pn-Diode, welche mit Vorder- und Rückseitenkontakten versehen ist. Die Vorderseitenkontakte bedecken dabei nur eine Teilfläche des Halbleitermaterials, so dass Sonnenlicht in das Halbleitermaterial eindringen kann. Die bei der Absorption des Lichtes entstehenden Elektronen-Loch-Paare driften zur Vorder- bzw. Rückseite und können über die Vorderseitenkontakte und die Rückseitenkontakte als elektrische Spannung abgegriffen werden. Solche photovoltaischen Zellen können beispielsweise zur elektrischen Energieversorgung eines Gebäudes verwendet werden.

Diese bekannten photovoltaischen Zellen weisen insbesondere beim Einsatz in transparenten Solarmodulen den Nachteil auf, dass an der Oberfläche der photovoltaischen Zellen Moire-Effekte auftreten können, welche den Betrachter einer damit ausgestatteten Gebäudefassade irritieren können. Schließlich bieten die bekannten photovoltaischen Zellen und daraus hergestellte Module eingeschränkte ästhetische Gestaltungsmöglichkeiten. Der Einsatz bekannter photovoltaischen Zellen und daraus hergestellter Module ist daher auf nicht sichtbare Dachflächen beschränkt.

Aus der US 2011/0290296 A1 ist ein flexibles Photovoltaikmodul bekannt, welches aus einer Mehrzahl kleiner Halbleitersubstrate zusammengesetzt ist. Dadurch ist das Photovoltaikmodul entlang der Fugen biegsam.

Die US 2011/0005569 A1 offenbart Solarzellen, welche in einer alternierenden, regelmäßigen Anordnung Halbleitermaterial und Isolierelemente enthalten. Die streifenförmigen Isolierelemente sind dazu eingerichtet und bestimmt, durch eine reflektierende Struktur eintreffendes Sonnenlicht auf das Halbleitermaterial zu lenken.

Aus der US 2011/0303260 A1 ist ein Solarmodul bekannt, welches eine Mehrzahl seriell miteinander verschalteter Solarzellen enthält.

Aus der US 2011/0174355 A1 ist eine Solarzelle bekannt, bei welcher sämtliche Anschlusskontakte auf der lichtabgewandten Rückseite angeordnet sind. Dadurch wird die Abschattung der Lichteintrittsfläche durch elektrische Kontakte vermieden.

Die US 2012/0085383 A1 zeigt ein Solarmodul mit geringerer Dicke, bei welchem elektrische Kontakte auf einem isolierenden Substrat aufgebracht und nachfolgend die Solarzellen durch Bonden aufgebracht werden.

Aus der EP 2 660 878 A1 ist ein Gewebe aus elektrisch leitfähigen und elektrisch isolierenden Fäden bekannt.

Ausgehend von diesem Stand der Technik liegt der Erfindung die Aufgabe zugrunde, eine photovoltaische Zelle anzugeben, welche vielfältigere Gestaltungsmöglichkeiten bietet und angenehm zu betrachten ist.

Die Aufgabe wird erfindungsgemäß durch ein Photovoltaikmodul gemäß Anspruch 1 und ein Gebäude gemäß Anspruch 13 gelöst.

Erfindungsgemäß wird vorgeschlagen, eine photovoltaische Zelle aus einer Mehrzahl flächig ausgebildeter Halbleitersubstrate mit jeweils einer Vorderseite und jeweils einer Rückseite zusammenzusetzen. Bisher bekannte photovoltaische Zellen verwenden im Gegensatz dazu stets ein einziges Halbleitersubstrat mit einer Vorder- und einer gegenüberliegenden Rückseite.

Durch Dotierung des Halbleitersubstrates bildet sich parallel zur Vorder- bzw. Rückseite zumindest ein pn-Übergang aus, an welchem eintreffendes Sonnenlicht absorbiert wird. Die entstehenden Elektronen-Loch-Paare wandern zur Vorder- bzw. zur Rückseite und können über die entsprechenden Kontakte als elektrische Spannung bzw. elektrischer Strom abgegriffen werden.

Erfindungsgemäß wurde nun erkannt, dass eine einzelne photovoltaische Zelle nicht zwingend aus einem einzigen flächig ausgebildeten Halbleitersubstrat gebildet werden muss. Vielmehr wird die erfindungsgemäße photovoltaische Zelle aus einer Mehrzahl von Halbleitersubstraten gebildet, welche jeweils eine Teilfläche der photovoltaischen Zelle bilden. Die einzelnen Teilflächen bzw. Teilzellen der photovoltaischen Zelle sind elektrisch parallel miteinander verschaltet. Hierdurch addiert sich der von den jeweiligen Teilflächen gebildete elektrische Strom, wohingegen die elektrische Spannung gleich bleibt.

Jedes einzelne Halbleitersubstrat aus der Mehrzahl flächig ausgebildeter Halbleitersubstrate trägt einen Vorderseitenkontakt auf seiner Vorderseite und einen Rückseitenkontakt auf seiner Rückseite. Der Vorderseitenkontakt belegt in jedem Fall nur eine Teilfläche des Halbleitersubstrates, so dass andere Teilflächen unbedeckt bleiben, um das Eindringen von Sonnenlicht zu ermöglichen. In einigen Ausführungsformen der Erfindung kann eine Mehrzahl von Vorderseitenkontakten vorhanden sein, welche beispielsweise in Form dünner Kontaktfinger bzw. Kontaktlinien ausgeformt sein können. Hierdurch kann der entstehende elektrische Strom effektiver abgeführt werden, da die Driftlängen der Minoritätsladungsträger im Halbleitersubstrat bis zum Erreichen des Vorderseitenkontakts geringer sind.

Der Rückseitenkontakt kann ebenfalls nur eine Teilfläche der Rückseite des Halbleitersubstrats bedecken und ebenfalls in Form von dünnen Kontaktfingern bzw. Kontaktlinien ausgebildet sein. In anderen Ausführungsformen der Erfindung kann der Rückseitenkontakt auch vollflächig aufgebracht sein, so dass sich eine vollständige bzw. nahezu vollständige Metallisierung der Rückseiten der Halbleitersubstrate ergibt.

In einigen Ausführungsformen der Erfindung kann das Halbleitersubstrat zumindest eine Bohrung aufweisen, welche eine elektrisch leitfähige Verbindung der Vorderseitenkontakte mit Anschlusselementen auf der Rückseite ermöglicht. Hierdurch können Abschattungen der Vorderseite durch die Stromschienen minimiert werden.

Die Vorderseitenkontakte und der Rückseitenkontakt können in einigen Ausführungsformen der Erfindung in an sich bekannter Weise durch Siebdruck, Aerosoldruck oder Tampondruck oder durch Abscheiden dünner Metallschichten im Vakuum aufgebracht werden. In einigen Ausführungsformen der Erfindung können die Kontakte galvanisch verstärkt werden, um die Stromtragfähigkeit zu verbessern. Das Material der Vorder- und Rückseitenkontakte wird in Abhängigkeit des Materials des Halbleitersubstrates und dessen Dotierung meist so gewählt, dass sich Ohm'sche Kontakte ergeben. In einigen Ausführungsformen der Erfindung können die Kontakte Silber, Gold oder Kupfer enthalten oder daraus bestehen.

Das Halbleitersubstrat selbst kann ein direktes Halbleitermaterial oder ein indirektes Halbleitermaterial enthalten. In einigen Ausführungsformen der Erfindung kann das Halbleitersubstrat aus Silizium bestehen oder Silizium enthalten. Daneben kann das Halbleitersubstrat Dotierstoffe enthalten, um eine vorgebbare elektrische Leitfähigkeit zu ermöglichen. Weiterhin kann das Halbleitersubstrat übliche Verunreinigungen enthalten. Das Halbleitersubstrat kann in einigen Ausführungsformen der Erfindung kristallin sein. Das Halbleitersubstrat kann in einigen Ausführungsformen der Erfindung amorph sein. Das Halbleitersubstrat kann in einigen Ausführungsformen der Erfindung eine Dicke von etwa 50 µm bis etwa 1000 µm oder eine Dicke von etwa etwa 100 µm bis etwa 500 µm aufweisen.

In einigen Ausführungsformen der Erfindung kann die photovoltaische Zelle eine Mehrzahl von Stromschienen aufweisen, deren Längserstreckungen entlang einer ersten Raumrichtung verlaufen und welche mit der Längserstreckung der Vorderseitenkontakte einen Winkel von etwa 20° bis etwa 90° oder einen Winkel von etwa 45° bis etwa 90° oder einen Winkel von etwa 80° bis etwa 90° einschließen. Die angegebenen Winkelbereiche bezeichnen dabei lediglich die Betragsangabe, so dass der Winkel zwischen der Längserstreckung der Vorderseitenkontakte und der Längserstreckung der Stromschienen in positiver oder negativer Richtung abgetragen werden kann. Die Mehrzahl von Stromschienen sorgt bei dieser Geometrie dafür, dass sich der Strom unterschiedlicher Teilflächen der photovoltaischen Zelle entlang der Längserstreckung der Stromschienen verteilt. Die in etwa orthogonal hierzu verlaufenden Vorderseitenkontakte verteilen den Strom in einer Richtung orthogonal zur Längserstreckung der Stromschienen, so dass alle Vorderseitenkontakte aller Halbleitersubstrate über die Stromschienen und die Vorderseitenkontakte benachbarter Halbleitersubstrate miteinander verbunden sind. In gleicher Weise sind die Rückseitenkontakte aller Halbleitersubstrate elektrisch miteinander verbunden, so dass Ausgleichsströme entlang der Längserstreckung der Stromschienen und über die Rückseitenkontakte auch in einer hierzu orthogonalen Richtung fließen können. Hierdurch wird die erfindungsgemäße Parallelschaltung der Teilflächen der photovoltaischen Zelle in einfacher Weise erreicht.

Die erfindungsgemäßen photovoltaischen Zellen können in an sich bekannter Weise zu einem Photovoltaikmodul zusammengefügt werden. Die erfindungsgemäßen photovoltaischen Zellen dürfen daher nicht mit einem bekannten Photovoltaikmodul verwechselt werden, welches ebenfalls eine Mehrzahl von photovoltaischen Zellen enthält, wobei die Zellen jedoch jeweils nur ein einzelnes Halbleitersubstrat aufweisen.

In einigen Ausführungsformen der Erfindung ist jede Stromschiene über zumindest einen Vorderseitenkontakt oder zumindest einen Rückseitenkontakt mit jeder anderen Stromschiene der entsprechenden Seite elektrisch leitfähig verbunden. Unter einer elektrischen leitfähigen Verbindung soll für die Zwecke der vorliegenden Erfindung eine Gleichstromkopplung zwischen den Stromschienen verstanden werden.

In einigen Ausführungsformen der Erfindung kann jede Stromschiene mit Ausnahme der randständigen Stromschienen mit zumindest zwei Vorderseitenkontakten oder zumindest zwei Rückseitenkontakten unterschiedlicher Halbleitersubstrate verbunden sein. Dies ist gleichbedeutend mit einer Geometrie, bei welcher unterschiedliche Halbleitersubstrate bzw. Teilflächen der photovoltaischen Zelle in einer Richtung orthogonal zur Längserstreckung der Stromschienen überlappen.

Erfindungsgemäß weisen zumindest zwei Halbleitersubstrate aus der Mehrzahl flächig ausgebildeter Halbleitersubstrate einer photovoltaischen Zelle eine unterschiedliche Form und/oder Größe auf. Dieses Merkmal hat die Wirkung, dass unregelmäßige, nicht periodische Strukturen realisierbar sind, bei welchen es praktisch ausgeschlossen ist, dass Moire-Effekte auftreten.

In einigen Ausführungsformen der Erfindung können die ersten Stromschienen und die zweiten Stromschienen in etwa parallel zueinander angeordnet sein, wobei die ersten und die zweiten Stromschienen in einer Richtung orthogonal zur Längserstreckung der Stromschienen zueinander versetzt sind. Hierdurch wird vermieden, dass in Teilflächen, an welchen sich kein Halbleitersubstrat befindet, die ersten und zweiten Stromschienen einen Kurzschluss verursachen.

In einigen Ausführungsformen der Erfindung kann die Mehrzahl flächig ausgebildeter Halbleitersubstrate aus dem gleichen Material bestehen. In einigen Ausführungsformen der Erfindung kann die Mehrzahl flächig ausgebildeter Halbleitersubstrate aus demselben Material bestehen. Sofern die einzelnen Halbleitersubstrate aus dem gleichen Material bestehen, erzeugen diese bei Bestrahlung mit Licht die gleiche elektrische Spannung, so dass eine Parallelschaltung der Teilflächen der photovoltaischen Zellen möglich wird, ohne dass große Ausgangsströme zwischen den einzelnen Halbleitersubstraten fließen. Weiterhin ist die Zellenspannung durch die Wahl des Halbleitermaterials definiert. Gleichwohl können Halbleitermaterialien aus unterschiedlichen Produktionschargen oder Reststücke aus der Halbleiterfertigung verwendet werden, welche bisher als Abfall entsorgt werden mussten. Hierdurch kann eine effizientere Ausnutzung des energieaufwändig hergestellten kristallinen Halbleitermaterials erreicht werden.

In einigen Ausführungsformen der Erfindung können die Halbleitersubstrate mit unterschiedlichen farbigen Beschichtungen versehen sein, um die Gestaltungsmöglichkeiten der photovoltaischen Zelle zu erweitern. Eine solche Beschichtung kann Siliciumnitrid in unterschiedlicher Dicke enthalten oder daraus bestehen, so dass die Beschichtung als Interferenzfilter wirkt und einen intensiven Farbeindruck erzeugt, ohne die Zellenspannung zu beeinflussen.

In anderen Ausführungsformen der Erfindung können die Halbleitersubstrate aus demselben Material bestehen, indem alle Halbleitersubstrate aus einem einzigen Wafer herausgeschnitten werden. Das Schneiden kann beispielsweise durch Lasertrennen oder spanende Bearbeitung erfolgen.

In einigen Ausführungsformen der Erfindung kann eine photovoltaische Zelle Teilstücke enthalten, welche nicht elektrisch mit den Stromschienen verbunden sind und/oder welche aus einem isolierenden Material gefertigt sind und zumindest einen Vorderseitenkontakt und/oder zumindest einen Rückseitenkontakt aufweisen, welcher elektrisch mit zumindest zwei Stromschienen verbunden ist. Der zusätzliche Einsatz von Teilstücken, welche nicht elektrisch mit den Stromschienen verbunden sind, kann dazu dienen, Teilflächen der photovoltaischen Zelle mit Material aufzufüllen, welches in etwa den gleichen optischen Eindruck wie die Halbleitersubstrate bietet. Hierdurch kann das ästhetische Erscheindungsbild der photovoltaischen Zelle an unterschiedliche Anforderungen angepasst werden. Teilstücke aus einem isolierenden Material, welche einen Vorderseitenkontakt und/oder einen Rückseitenkontakt aufweisen, können an Stellen eingesetzt werden, an welchen kein photovoltaisch aktives Halbleitersubstrat vorgesehen ist, an welchem jedoch ein Stromfluss zwischen unterschiedlichen Stromschienen erforderlich ist, um die gewünschte Parallelschaltung der einzelnen Halbleitersubstrate zu ermöglichen.

Erfindungsgemäß weist die Mehrzahl flächig ausgebildeter Halbleitersubstrate jeder photovoltaischen Zelle den gleichen Flächeninhalt auf. Hierdurch ist sichergestellt, dass unterschiedliche photovoltaische Zelle trotz unterschiedlichen Aussehens und unterschiedlicher Gesamtfläche den gleichen elektrischen Strom liefern. Als Gesamtfläche wird dabei die Summe der Flächen der Halbleitersubstrate und der Zwischenräume angesehen. Dies ermöglicht eine verlustarme Serienschaltung unterschiedlicher photovoltaischer Zellen innerhalb eines Photovoltaikmoduls. In anderen Ausführungsformen der Erfindung können Zellen aus unterschiedlichen Material miteinander verschaltet werden, welche jeweils den selben Strom liefern. Hierzu kann die jeweilige aktive Fläche der Zellen so angepasst werden, dass Materialen mit geringer Stromausbeute größere Flächen aufweisen als Materialien mit höherer Stromausbeute.

In einigen Ausführungsformen der Erfindung können die Stromschienen in einer Einbettungsfolie eingebettet sein. Hierdurch wird die Handhabung bei der Montage bzw. der Herstellung der erfindungsgemäßen photovoltaischen Zellen bei der Herstellung von Photovoltaikmodulen wesentlich erleichtert. In einigen Ausführungsformen der Erfindung kann die Einbettungsfolie eine Klebstoffschicht aufweisen und/oder mit den Halbleitersubstraten verschweißt werden, um die erfindungsgemäße photovoltaische Zelle herzustellen.

Nachfolgend soll die Erfindung anhand von Figuren ohne Beschränkung des allgemeinen Erfindungsgedankens näher erläutert werden. Dabei zeigt
Fig. 1 einen ersten Verfahrensschritt zur Herstellung einer photovoltaischen Zelle.
Fig. 2 zeigt einen zweiten Verfahrensschritt zur Herstellung einer photovoltaischen Zelle.
Fig. 3 zeigt einen dritten Verfahrensschritt zur Herstellung einer photovoltaischen Zelle.
Fig. 4 erläutert einen Verfahrensschritt zur Herstellung einer ersten Ausführungsform eines erfindungsgemäßen Photovoltaikmoduls.
Fig. 5 erläutert einen weiteren Verfahrensschritt zur Herstellung eines erfindungsgemäßen Photovoltaikmoduls.
Fig. 6 zeigt eine erste alternative Ausführungsform der erfindungsgemäßen photovoltaischen Zelle.
Fig. 7 zeigt eine zweite alternative Ausführungsform der erfindungsgemäßen photovoltaischen Zelle.
Fig. 8 zeigt unterschiedliche Halbleitersubstrate.
Fig. 9 zeigt einen ersten Herstellungsschritt zur Herstellung der Halbleitersubstrate.
Fig. 10 zeigt einen zweiten Verfahrensschritt zur Herstellung der Halbleitersubstrate.
Fig. 11 zeigt einen dritten Verfahrensschritt zur Herstellung der Halbleitersubstrate.
Fig. 12 zeigt einen vierten Verfahrensschritt zur Herstellung der Halbleitersubstrate.
Fig. 13 zeigt einen fünften Verfahrensschritt zur Herstellung der Halbleitersubstrate.
Fig. 14 zeigt einen Querschnitt durch eine erfindungsgemäße photovoltaische Zelle.
Fig. 15 zeigt ein erstes Anwendungsbeispiel der erfindungsgemäßen Photovoltaikmodule.
Fig. 16 zeigt ein zweites Anwendungsbeispiel der erfindungsgemäßen Halbleitermodule.
Fig. 17 zeigt ein drittes Anwendungsbeispiel der erfindungsgemäßen Halbleitermodule.
Fig. 18 zeigt eine zweite Ausführungsform eines erfindungsgemäßen Photovoltaikmoduls.
Fig. 19 zeigt eine erste Ausführungsform eines erfindungsgemäßen Photovoltaikmoduls im Schnitt.
Fig. 20 zeigt eine dritte Ausführungsform eines erfindungsgemäßen Photovoltaikmoduls im Schnitt.
Fig. 21 zeigt eine vierte Ausführungsform eines erfindungsgemäßen Photovoltaikmoduls im Schnitt.
Fig. 22 zeigt eine fünfte Ausführungsform eines erfindungsgemäßen Photovoltaikmoduls im Schnitt.
Fig. 23 zeigt die sechste Ausführungsform des erfindungsgemäßen Photovoltaikmoduls in Axonometrie.
Fig. 24 zeigt eine alternative Ausführungsform von Halbleitersubstraten im Schnitt.
Fig. 25 zeigt eine siebte Ausführungsform eines erfindungsgemäßen Photovoltaikmoduls.

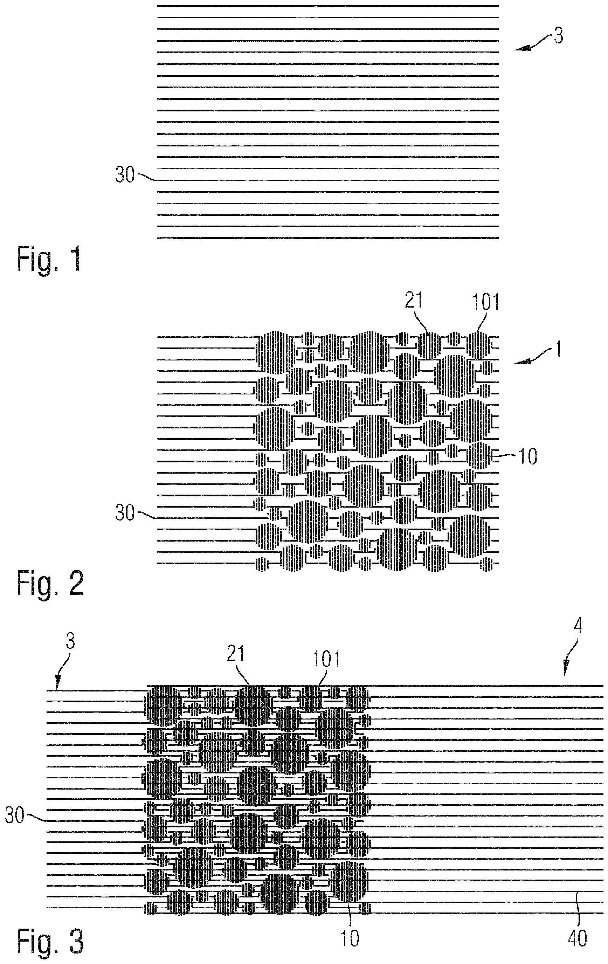

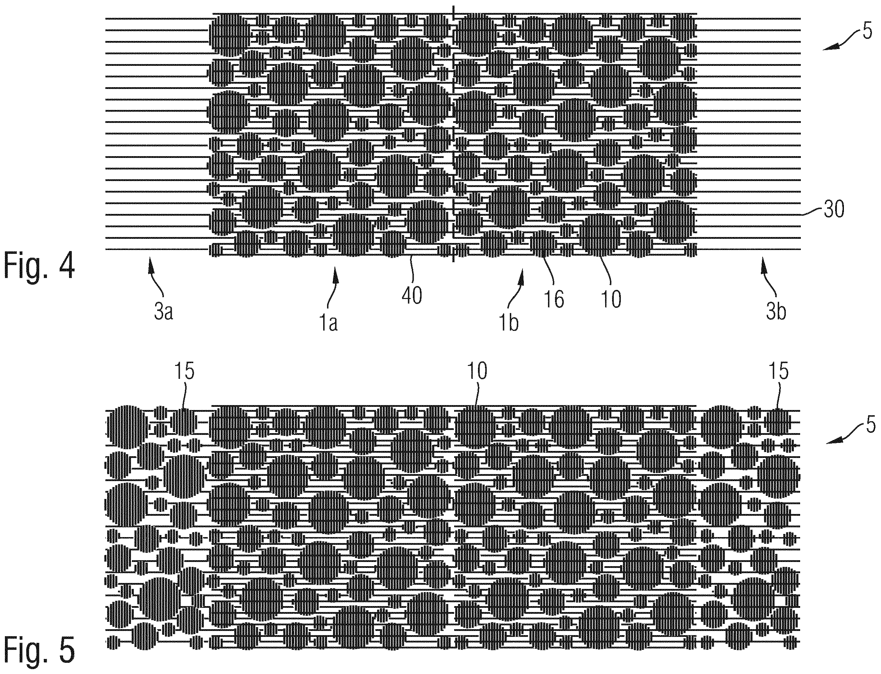

Anhand der Figuren 1 bis 3 wird ein mögliches Herstellungsverfahren der photovoltaischen Zelle gemäß der vorliegenden Erfindung erläutert. Die Figuren 4 und 5 erläutern die mögliche Weiterverarbeitung der photovoltaischen Zelle zu einem Photovoltaikmodul mit mehreren photovoltaischen Zellen.

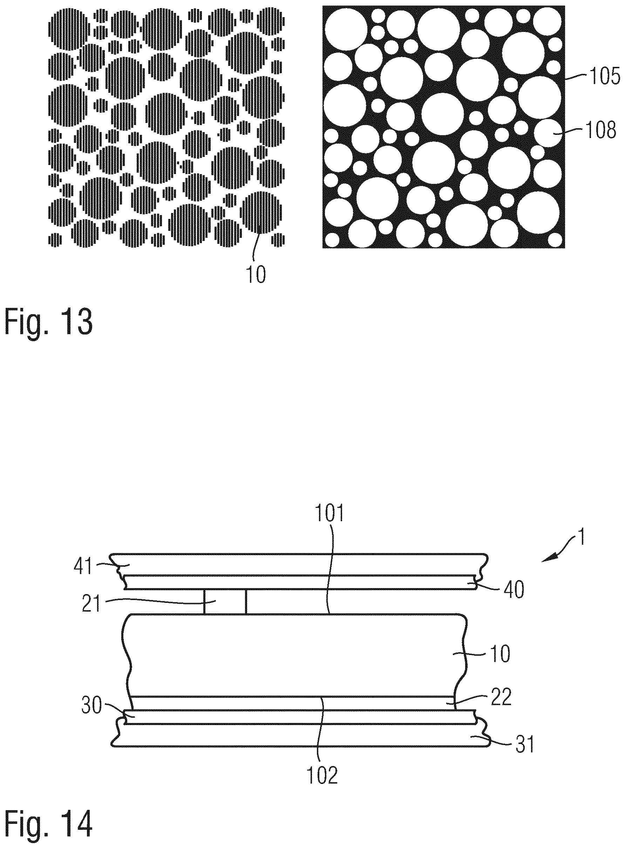

Im ersten Verfahrensschritt wird eine Mehrzahl 3 zweiter Stromschienen 30 bereitgestellt, wie in Fig. 1 dargestellt. Die Stromschienen 1 können beispielsweise als Drähte mit rundem oder polygonalem Querschnitt ausgeführt sein. Der Durchmesser der Stromschienen 30 kann zwischen etwa 0,1 mm und etwa 1 mm betragen. In einigen Ausführungsformen der Erfindung können die Stromschienen 30 Gold, Silber, Aluminium oder Kupfer enthalten oder daraus bestehen. Der Abstand zweier benachbarter Stromschienen 30 kann zwischen etwa 1 mm und etwa 50 mm oder zwischen etwa 1 mm und etwa 10 mm betragen. Um die Handhabung zu vereinfachen, kann eine Mehrzahl von Stromschienen 30 in einer Einbettungsfolie 31 aufgenommen sein, wie später anhand von Fig. 14 näher erläutert wird.

In Fig. 2 ist dargestellt, wie im zweiten Verfahrensschritt eine Mehrzahl von Halbleitersubstraten 10 mit deren Rückseitenkontakten 22 auf die Mehrzahl 3 von Stromschienen 30 aufgebracht wird. Eine elektrisch leitfähige Verbindung zwischen den Stromschienen 30 und den Rückseitenkontakten 22 kann in einigen Ausführungsformen der Erfindung durch Löten, Punktschweißen oder durch elektrisch leitfähige Klebstoffe erzielt werden. Hierdurch kann gleichzeitig eine mechanische Befestigung zwischen den Stromschienen 30 und den Halbleitersubstraten 10 erreicht werden. In anderen Ausführungsformen der Erfindung kann die mechanische Befestigung der Halbleitersubstrate 10 auch durch Verkleben oder Verschweißen mit der Einbettungsfolie erfolgen. In diesem Fall kann eine separate stoffschlüssige Verbindung der Rückseitenkontakte mit den Stromschienen 30 unterbleiben.

Wie aus Fig. 2 ersichtlich ist, können die Halbleitersubstrate 10 einer einzigen photovoltaischen Zelle 1 unterschiedliche Größen aufweisen. Die einzelnen Halbleitersubstrate 10 können in einem regelmäßigen oder einem unregelmäßigen Muster innerhalb der photovoltaischen Zelle 1 angeordnet sein. Weiterhin ist in Fig. 2 erkennbar, dass zumindest die Vorderseitenkontakte 21 der Halbleitersubstrate 10 eine streifenartige Strukturierung aufweisen. Hierdurch wird erreicht, dass die Vorderseitenkontakte 21 nur eine Teilfläche eines jeden Halbleitersubstrates 10 belegen und ein Teil der Vorderseite 101 für den Lichteintritt in die Halbleitersubstrate 10 zur Verfügung steht.

Fig. 2 zeigt, dass die Längserstreckung der Vorderseitenkontakte 21 in etwa orthogonal zur Längserstreckung der Stromschienen 30 verläuft. Hierdurch wird sichergestellt, dass eine elektrische Parallelschaltung aller Halbleitesubstrate 10 einer photovoltaischen Zelle 1 vorliegt. Das elektrische Potential entlang der Stromschienen 30 wird durch die elektrische Leitfähigkeit der Stromschienen 30 ausgeglichen. Eine Potentialdifferenz zwischen den Stromschienen 30 kann durch die elektrisch leitfähige Verbindung der Stromschienen mit den Vorder- bzw. Rückseitenkontakten über diese Kontakte ausgeglichen werden. Somit sind alle Vorderseiten der Halbleitersubstrate 10 und alle Rückseiten der Halbleitersubstrate 10 gleichstromgekoppelt und liegen damit auf einheitlichem elektrischem Potential.

Fig. 3 zeigt die Fertigstellung der photovoltaischen Zelle durch Aufbringen einer Mehrzahl 4 erster Stromschienen 40. Die ersten Stromschienen 40 können ebenfalls aus einem Draht mit rundem oder polygonalen Querschnitt gefertigt sein und optional in einer Einbettungsfolie fixiert werden, wie bereits vorstehend anhand der zweiten Stromschienen 3 näher erläutert. Die ersten Stromschienen 40 sind dazu vorgesehen, die Vorderseitenkontakte 21 der Halbleitersubstrate 10 zu kontaktieren. Da die meisten Stromschienen 40 zumindest zwei Vorderseitenkontakte zumindest zweier unterschiedlicher Halbleitersubstrate 10 kontaktieren, sind auch die ersten Stromschienen 40 alle leitfähig untereinander verbunden, so dass diese auf gleichem elektrischem Potential liegen und sich die erfindungsgemäße Parallelschaltung der Halbleitersubstrate 10 ergibt.

Um einen Kurzschluss zwischen den ersten Stromschienen 40 und den zweiten Stromschienen 30 zu vermeiden kann vorgesehen sein, die ersten und die zweiten Stromschienen versetzt zueinander anzuordnen, so dass die zweiten Stromschienen in den Lücken zwischen zwei ersten Stromschienen zu liegen kommen und die ersten Stromschienen in den Lücken zwischen zwei zweiten Stromschienen zu liegen kommen.

Fig. 4 zeigt die Weiterverarbeitung der photovoltaischen Zelle 1 zu einer ersten Ausführungsform eines Photovoltaikmoduls 5. Hierzu kann eine Mehrzahl von Halbleitersubstraten 10 mit den jeweiligen Rückseitenkontakten auf die ersten Stromschienen 4 der vorhergehenden photovoltaischen Zelle aufgebracht werden. Daraufhin können erneut zweite Stromschienen 3 auf die Vorderseite der photovoltaischen Zellen 10 aufgebracht werden. Hierdurch ergibt sich eine Serienverschaltung der benachbarten photovoltaischen Zellen innerhalb des Photovoltaikmoduls 5.

Um eine effiziente Parallelschaltung der einzelnen Halbleitersubstrate innerhalb eine photovoltaischen Zelle zu ermöglichen, können diese aus dem gleichen oder demselben Material gefertigt sein, so dass sich bei konstanter Beleuchtung die gleiche Zellenspannung einstellt. Um eine effiziente Serienverschaltung der photovoltaischen Zellen innerhalb des Photovoltaikmoduls zu ermöglichen kann vorgesehen sein, dass die aktive Fläche aller innerhalb einer photovoltaischen Zelle verarbeiteten Halbleitersubstrate identisch ist, so dass jede photovoltaische Zelle bei gleicher Lichtintensität den gleichen elektrischen Strom liefern kann. Sofern sich Unterschiede in der Stromlieferfähigkeit ergeben, können in einigen photovoltaischen Zellen Teilstücke 16 angeordnet sein, welche aus einem Isolator bestehen und wie photovoltaischen Zellen mit Vorder- und Rückseitenkontakten versehen sind. Diese Teilstücke 16 können dazu eingesetzt werden, den Stromfluss zwischen Stromschienen zu ermöglichen. Da die Teilstücke 16 jedoch selbst keine elektrische Energie liefern, kann durch den Einsatz dieser Teilstücke 16 eine Feinanpassung des von der photovoltaischen Zelle 1 gelieferten Stromes erfolgen. In gleicher Weise können auch Teilstücke 15 eingesetzt werden, welche aus einem isolierenden Material bestehen, wenn ein Stromfluss über die Grenzen der Stromschienen hinweg bereits durch die Halbleitersubstrate der photovoltaischen Zelle sichergestellt ist.

Fig. 5 zeigt einen weiteren Verfahrensschritt zur Herstellung eines Photovoltaikmoduls gemäß der Erfindung. Wie in Fig. 5 dargestellt ist, können die freien Enden 3a und 3b der Stromschienen mit Teilstücken 15 aus isolierendem Material belegt werden, um ein einheitliches optisches Erscheinungsbild der photovoltaischen Zelle bzw. daraus geertigter Module über deren gesamte Fläche sicherzustellen.

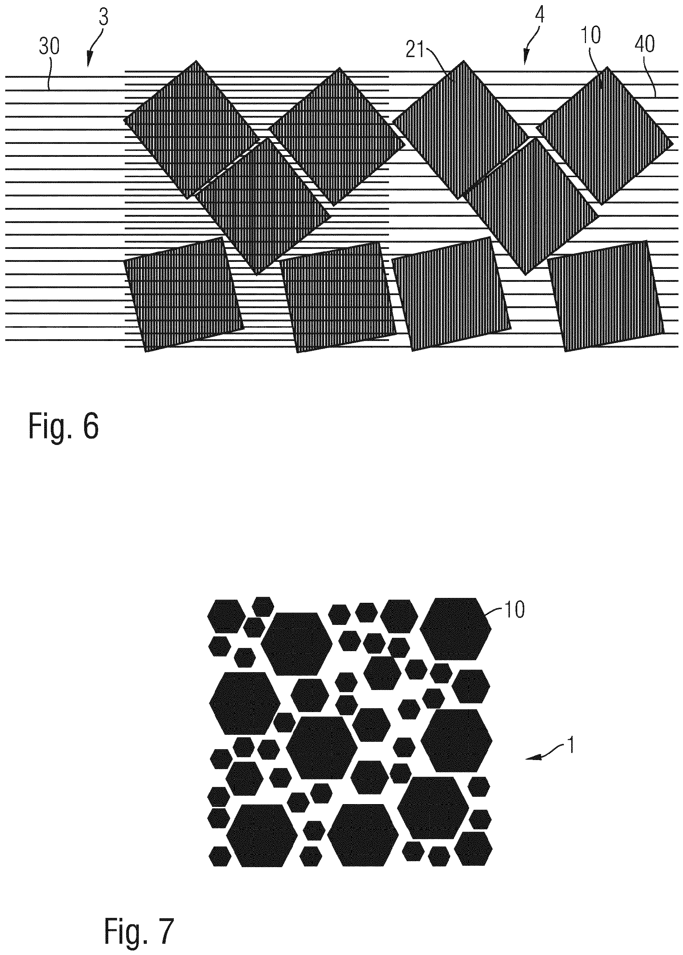

Fig. 6 zeigt eine zweite Ausführungsform der photovoltaischen Zelle bzw. des Photovoltaikmoduls, die nicht Teil der Erfindung ist.

Gleiche Bestandteile sind mit gleichen Bezugszeichen versehen, so dass sich die Beschreibung auf die wesentlichen Unterschiede beschränkt.

Wie in Fig. 6 gezeigt ist, weisen die Halbleitersubstrate 10 statt einer runden Grundfläche eine quadratische Grundfläche auf. Auch enthält die photovoltaische Zelle gemäß der zweiten Ausführungsform lediglich einheitliche Halbleitersubstrate gleicher Größe. Wie Fig. 6 weiter ersichtlich ist, ist die Anordnung der Vorderseitenkontakte 21 auf den einzelnen Halbleitersubstraten 10 unterschiedlich, so dass auch bei unterschiedlicher relativer Lage der Halbleitersubstrate 10 zu den Stromschienen 40 bzw. 30 sichergestellt ist, dass die Vorderseitenkontakte 21 in etwa orthogonal zu den Stromschienen 30 und 40 verlaufen. Auf die exakte Einhaltung eines rechten Winkels zwischen der Längserstreckung der Vorderseitenkontakte 21 und der Längserstreckung der Stromschienen 30 und 40 kommt es jedoch erkennbar nicht an, solange die Vorderseitenkontakte eine Mehrzahl von Stromschienen kontaktieren und für einen Potentialausgleich zwischen den Stromschienen sorgen können.

Fig. 7 zeigt eine dritte Ausführungsform der Halbleitersubstrate 10. Gemäß der dritten Ausführungsform werden polygonale Halbleitersubstrate in drei unterschiedlichen Größen verwendet. Die polygonale Grundform gemäß Fig. 7 weist sechs Ecken auf, wobei selbstverständlich auch eine größere oder eine geringere Anzahl von Ecken verwendet werden kann. Auch können unregelmäßig geformte polygonale Grundformen verwendet werden. Wesentlich ist lediglich, dass die Summe der Flächeninhalte der Halbleitersubstrate aller photovoltaischen Zellen innerhalb eines Photovoltaikmoduls gleich ist. Die Aufteilung dieser Summe in unterschiedliche Teilflächen kann jedoch variieren.

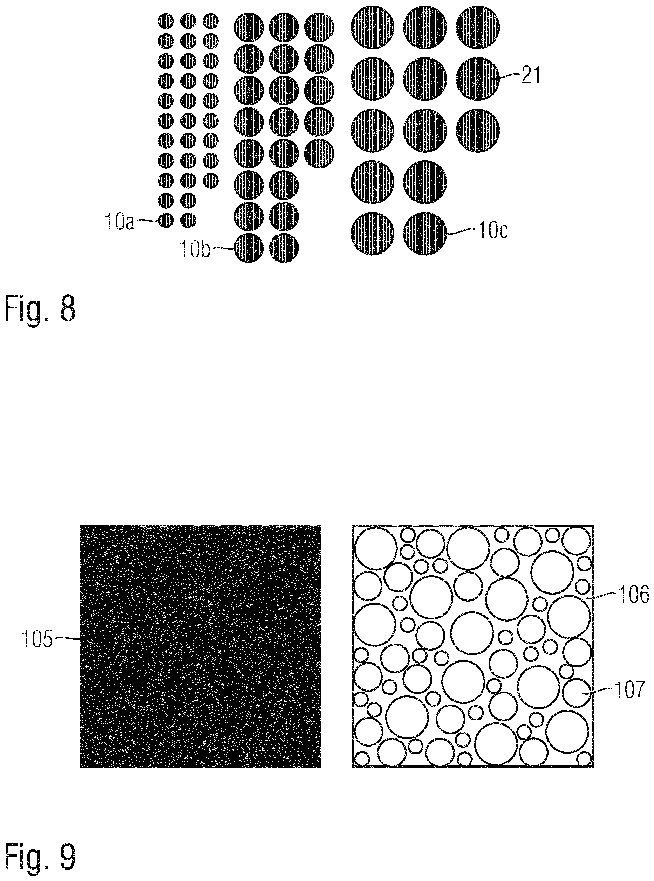

Fig. 8 zeigt nochmals Halbleitersubstrate 10a, 10b und 10c, in drei Größen, welche innerhalb einer photovoltaischen Zelle verwendbar sind. Die Halbleitersubstrate 10a, 10b und 10c weisen jeweils runde Grundformen auf, unterscheiden sich jedoch in der Größe. Beispielhaft sind in Fig. 8 erste Halbleitersubstrate 10a mit einem geringen Durchmesser, zweite Halbleitersubstrate 10b mit einem mittleren Durchmesser und dritte Halbleitersubstrate 10c mit einem großen Durchmesser gezeigt.

Jedes Halbleitersubstrat 10a, 10b und 10c weist eine Mehrzahl von Vorderseitenkontakten auf, welche die Form länglicher Kontaktfinger annehmen. Die Vorderseitenkontakte können bis dicht an den Rand der Halbleitersubstrate 10a, 10b und 10c geführt sein. Der Rand selbst kann jedoch frei bleiben um einen Kurzschluss zwischen Vorder- und Rückseitenkontakt zu vermeiden.

Der Rückseitenkontakt kann in gleicher Weise ausgeführt sein wie der Vorderseitenkontakt oder aber eine vollflächige Metallisierung umfassen. Die Vorder- und Rückseitenkontakte können auf jedes einzelne Halbleitersubstrat 10a, 10b und 10c in an sich bekannter Weise aufgebracht werden, beispielsweise durch Abscheiden und nachträglichen Strukturieren einer Metallschicht, durch ein Druckverfahren oder durch außenstromloses oder galvanisches Abscheiden.

Die runden Halbleitersubstrate 10a, 10b und 10c können durch ein Trennverfahren, beispielsweise Laserschneiden, aus einem größeren Substrat gefertigt werden. In anderen Ausführungsformen können runde Ausgangsmaterialien bzw. Wafer unmittelbar Verwendung finden, ohne dass ein weiterer Zuschnitt erforderlich ist.

Anhand der Figuren 9 bis 13 wird ein alternatives Herstellungsverfahren für die Halbleitersubstrate 10 näher erläutert. Das Herstellungsverfahren erlaubt eine Fertigung einer Mehrzahl von Halbleitersubstraten 10 mit geringem zeiteinsatz.

Fig. 9 zeigt ein Basissubstrat 105 als Ausgangsmaterial. Dass Basissubstrat 105 kann ein bereits vorgeschnittenes, rechtwinkliges Substrat sein oder aber ein vollständiger Wafer, wie er in der Mikroelektronik als Ausgangsmaterial bekannt ist. Das Basissubstrat 105 kann eine Dotierung aufweisen, um vorgebbare elektrische Leitfähigkeiten zu erzielen. Das Basissubstrat 105 kann bereits eine fertig prozessierte PN-Diode enthalten, welche als Grundelement der photovoltaischen Zelle dient.

Weiterhin zeigt Fig. 9 eine Maske 106, welche eine Mehrzahl von Ausnehmung 107 enthält. Die Maske 106 kann beispielsweise eine Folie, eine Glasplatte oder eine Keramik als Ausgangsmaterial enthalten. Die Ausnehmungen 107 definieren die spätere Lage der Halbleitersubstrate 10a, 10b und 10c auf dem Basissubstrat 105, welche für die photovoltaische Zelle 1 verwendet werden sollen.

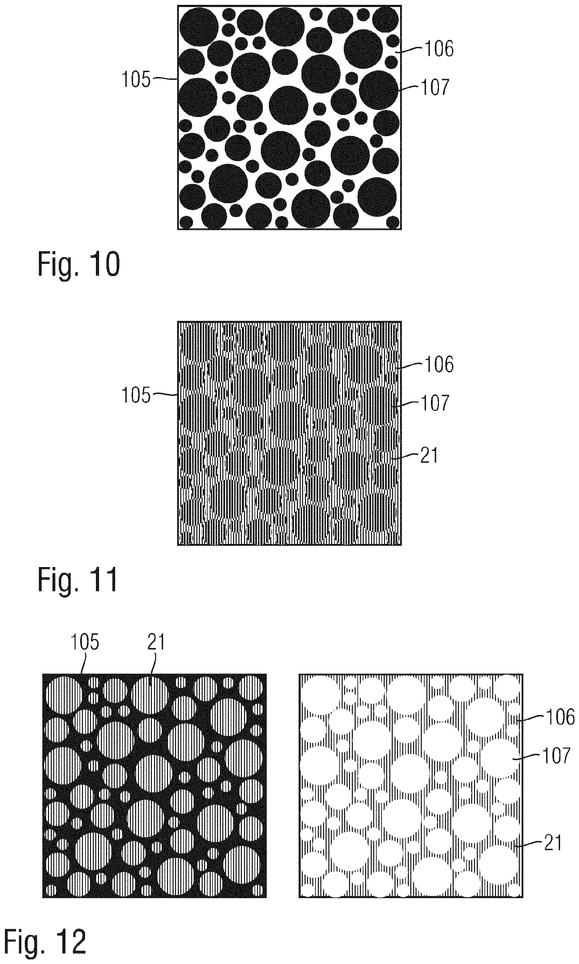

Fig. 10 erläutert, wie die Maske 106 auf das Basissubstrat 105 aufgelegt wird, so dass die Maske Teilflächen des Basissubstrates 105 bedeckt und die Ausnehmungen 107 Teilflächen des Substrats freilassen.

In Fig. 11 ist dargestellt, wie eine Mehrzahl von Vorderseitenkontakten 21 durch ein Druckverfahren, beispielsweise Siebdruck, Tampondruck oder Aerosoldruck auf die Oberfläche der Maske 106 und des Basissubstrates 105 aufgedruckt werden.

In Fig. 12 ist der nächste Verfahrensschritt dargestellt, nämlich das Abnehmen der Maske 106 vom Basissubstrat 105. Wie in Fig. 12 ersichtlich ist, ist das Basissubstrat 105 nur in den durch die Ausnehmungen 107 exponierten Teilflächen mit den Vorderseitenkontakten 21 versehen. Im letzten Verfahrensschritt können die Halbleitersubstrate 10 durch ein Trennverfahren aus dem Basissubstrat 105 ausgeschnitten werden. Beispielsweise eignet sich Laserschneiden zur Erzeugung beliebiger Freiformen der Halbleitersubstrate 10. Es verbleibt nach Abschluss dieses Verfahrensschrittes ein Basissubstrat 105 mit einer Mehrzahl von Löchern 108, welches entweder als Maske für die Herstellung einer weiteren Mehrzahl von Halbleitersubstraten 10 verwendbar ist oder welches der Entsorgung zugeführt werden kann.

Sofern die durch die Schnittführung definierte Außenkontur der Halbleitersubstrate 10 geringfügig größer ist als die Kontur der Ausnehmungen 107 kann sichergestellt werden, dass um die Vorderseitenkontakte 21 ein Rand verbleibt, welcher zuverlässig einen Kurzschluss zwischen Vorder- und Rückseitenkontakt verhindern kann.

Fig. 14 zeigt den Querschnitt durch eine photovoltaische Zelle gemäß Fig. 3.

Im mittleren Bildteil der Fig. 14 ist ein Halbleitersubstrat 10 dargestellt. Das Halbleitersubstrat 10 weist eine Vorderseite 101 und eine gegenüberliegende Rückseite 102 auf. Auf der Vorderseite 101 ist eine Mehrzahl von Vorderseitenkontakten 21 angeordnet. Der in Fig. 14 dargestellte Ausschnitt zeigt jedoch lediglich einen einzigen Vorderseitenkontakt 21. Der Vorderseitenkontakt 21 kann als Metallisierung einer Teilfläche auf der Vorderseite 101 ausgeführt sein.

Auf der Rückseite 102 befindet sich ein Rückseitenkontakt 22. Im dargestellten Ausführungsbeispiel ist der Rückseitenkontakt 22 durch eine vollflächige Metallisierung gebildet. Auch der Rückseitenkontakt 22 kann jedoch eine Strukturierung aufweisen, wie anhand des Vorderseitenkontaktes 21 beschrieben.

Der Rückseitenkontakt 22 ist mit zweiten Stromschienen 30 kontaktiert. Die zweiten Stromschienen 30 sind in einer Einbettungsfolie 31 eingebettet. Dabei ist nur ein Teil des Querschnitts der Stromschienen 30 in der Einbettungsfolie 31 aufgenommen, so dass eine metallische Fläche der Stromschiene 30 in Richtung des Rückseitenkontaktes 22 exponiert ist.

Die Einbettungsfolie 31 kann darüber hinaus mit einer Klebstoffschicht versehen sein, um durch Auflegen und Anpressen der Einbettungsfolie 31 sowohl die Stromschienen 30 mit dem Rückseitenkontakt 22 zu kontaktieren als auch einen mechanisch robusten Verbund zwischen den Stromschienen und den Halbleitersubstraten 10 zu ermöglichen.

In gleicher Weise sind erste Stromschienen 40 in einer Einbettungsfolie 41 aufgenommen. Die ersten Stromschienen 40 sind auf der ersten Seite 101 des Halbleitersubstrats 1 aufgelegt, so dass diese die Vorderseitenkontakte 21 kontaktieren. Zumindest die Einbettungsfolie 41 kann transparent oder transluzent ausgeführt sein, so dass bei Betrieb der photovoltaischen Zelle Sonnenlicht auf die erste Seite 101 der Halbleitersubstrate 10 fällt.

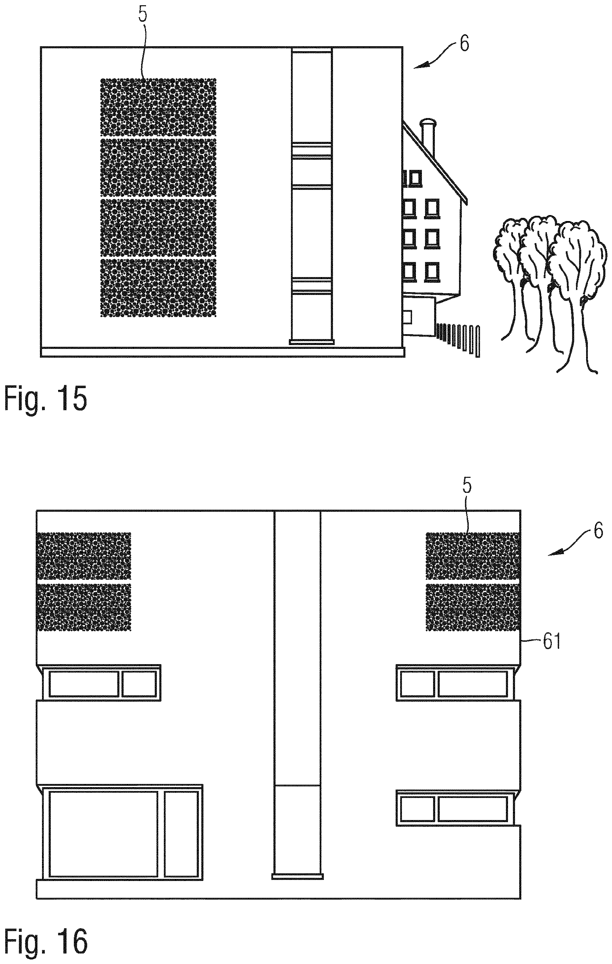

Fig. 15 zeigt ein Anwendungsbeispiel eines erfindungsgemäßen Photovoltaikmoduls 5. Das Photovoltaikmodul 5 ist an einer Fassade 6 angeordnet. Die Montage kann entweder in an sich bekannter Weise durch hinterlüftete Halterungen erfolgen, so dass ein Wärmestau in den Halbleitersubstraten 10 vermieden wird. In anderen Ausführungsformen der Erfindung kann das Photovoltaikmodul 5 integraler Bestandteil eines Fassadenelements sein, welches an dem Gebäude 6 vorgehängt wird. Hierdurch kann in einem einzigen Arbeitsschritt sowohl die Fassade gestaltet als auch die Photovoltaikanlage installiert werden.

Fig. 15 zeigt eine Gebäudefassade, welche in Naturstein oder anderen mineralischen Baustoffen hergestellt ist.

Fig. 16 zeigt eine weitere Anwendung der vorliegenden Erfindung. Auch Fig. 16 zeigt ein Gebäude 6 mit einem Fassadenelement 61, welches das erfindungsgemäße Photovoltaikmodul 5 enthält. Das Fassadenelement 61 gemäß Fig. 16 kann aus Holz oder Holzwerkstoffen gefertigt sein.

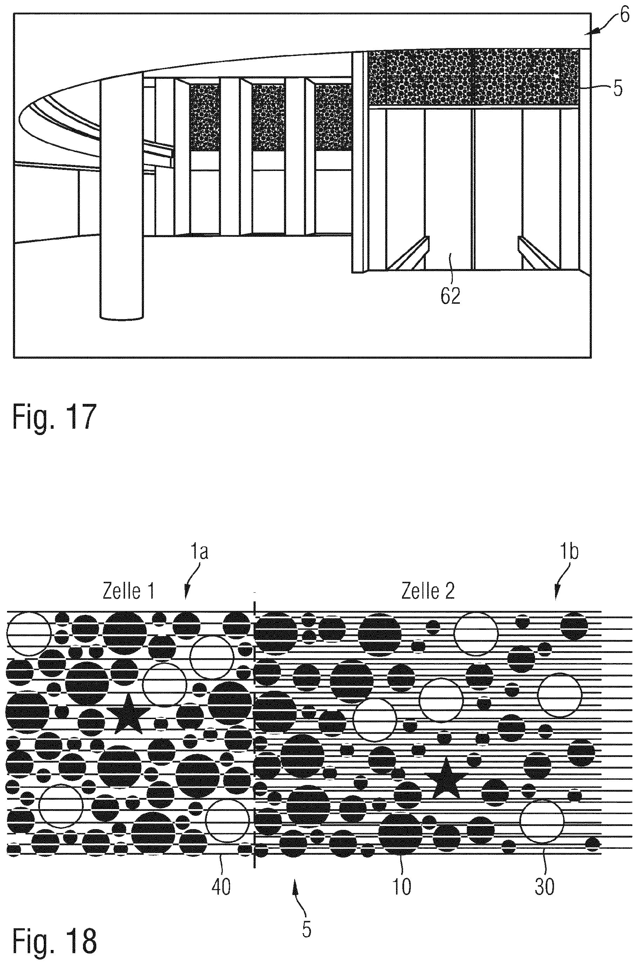

Fig. 17 erläutert die Integration der erfindungsgemäßen Photovoltaikmodule 5 in ein Fensterelement 62 eines Gebäudes 6. Da die Halbleitersubstrate 10 nicht die gesamte Fläche der photovoltaischen Zellen 1 belegen, kann zwischen einzelnen Halbleitersubstraten 10 Licht hindurchtreten. Hierdurch bleiben die mit den Photovoltaikmodulen belegten Teilbereiche der Fenster 62 weiterhin transluzent, so dass ein Lichteinfall ins Gebäude weiterhin möglich ist. In Abhängigkeit der Belegungsdichte mit Halbleitersubstraten 10 kann auch der Ausblick aus dem Fenster 62 weiterhin möglich sein.

Fig. 18 zeigt eine zweite Ausführungsform eines erfindungsgemäßen Photovoltaikmoduls. Dargestellt sind exemplarisch zwei photovoltaische Zelle 1a und 1b. In anderen Ausführungsformen der Erfindung kann die Anzahl der photovoltaischen Zellen 1 im Photovoltaikmodul 5 größer sein.

Jede photovoltaische Zelle 1a und 1b ist aus einer Mehrzahl von Halbleitersubstraten 10 zusammengesetzt, welche mit ersten Stromschienen 40 und zweiten Stromschienen 30 parallel miteinander verschaltet sind, wohingegen die erste Zelle 1a und die zweite Zelle 1b eine elektrische Serienschaltung bilden.

Wie in Fig. 18 ersichtlich ist, sind die Halbleitersubstrate 10 der ersten Zelle 1a mit vergleichsweise geringem relativen Abstand zueinander angeordnet. Die Halbleitersubstrate 10 der zweiten Zelle 1b weisen einen größeren Abstand zueinander auf, so dass die zweite Zelle 1b eine größere Gesamtfläche belegt. Als Gesamtfläche wird dabei die Summe der Flächen der Halbleitersubstrate und der Zwischenräume angesehen. Gleichwohl ist die aktive Fläche, d.h. die Summe der Flächen der jeweiligen Halbleitersubstrate 10, der ersten Zelle 1a und der zweiten Zelle 1b gleich groß. Hieraus ergeben sich die gleichen elektrischen Parameter, nämlich Strom und Spannung, so dass eine Serienschaltung der beiden photovoltaischen Zellen 1a und 1b problemlos möglich ist.

Die unterschiedliche Bruttofläche der photovoltaische Zellen 1a und 1b ermöglicht unterschiedliche Gestaltungsmöglichkeiten an einer Fassade. Beispielsweise kann die Illusion des Auslaufens bzw. Zerfließens des Photovoltaikmoduls 5 an seinen Rändern erzielt werden. Bisher bekannte Photovoltaikmodule mit identischen photovoltaischen Zellen weisen demgegenüber stets geometrisch bestimmte, meist geradlinige Ränder auf. Weiterhin kann die photovoltaische Zelle 1b mit größerer Bruttofläche im Bereich von Lichtbändern oder Fensteröffnungen eingesetzt werden, um so den Lichteintritt in das Gebäude oder die freie Sicht der Bewohner aus dem Gebäude heraus zu ermöglichen. In anderen Flächenbereichen der Fassade erlaubt die photovoltaische Zelle 1a eine größere Energieausbeute pro Flächenelement aufgrund ihrer dichteren Belegung mit Halbleitersubstraten 10.

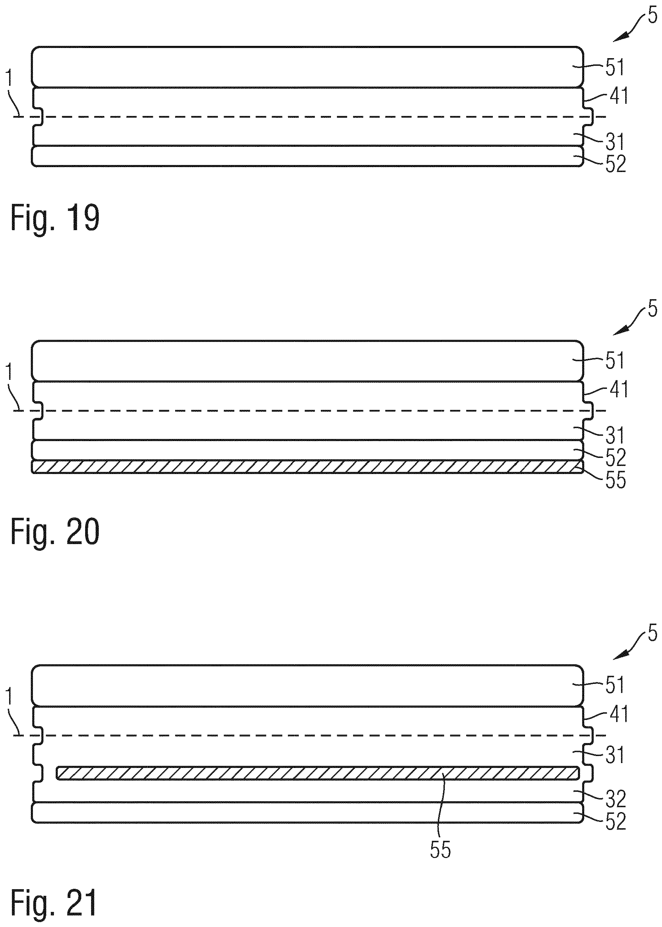

Fig. 19 zeigt die erste Ausführungsform des erfindungsgemäßen Photovoltaikmoduls im Schnitt. Das Photovoltaikmodul 5 weist ein Deckglas 51 auf, welches zum Eintritt von Sonnenenergie vorgesehen ist. Unterhalb des Deckglases 51 befindet sich eine obere Einbettungsfolie 41 sowie eine untere Einbettungsfolie 31, welche die photovoltaischen Zellen 1 einbettet, wie anhand von Fig. 14 bereits erläutert. Fakultativ können die Einbettungsfolien 41 und 31 auch die Stromschienen tragen, wie anhand von Fig. 14 erläutert.

Die Einbettungsfolien 41 und 31 können miteinander verschweißt sein, um das Eindringen von Feuchtigkeit zu vermeiden. Beim Verschweißen können gleichzeitig die Lötverbindungen zwischen den Vorder- und Rückseitenkontakten der photovoltaischen Zellen 1 und den Stromschienen 30 und 40 ausgeführt werden.

An die Einbettungsfolie 31 schließt sich eine Rückseitenabdeckung 52 an. Die Rückseitenabdeckung kann in einigen Ausführungsformen der Erfindung transparent oder transluzent sein, so dass zwischen den Halbleitersubstraten 10 eine freie Durchsicht durch das Photovoltaikmodul gegeben ist. Alternativ kann die Rückseitenabdeckung 52 eine farbliche Gestaltung aufweisen, welche entweder das geometrische Muster der Halbleitersubstrate 10 betont oder aber das Vorhandensein der Halbleitersubstrate 10 vor dem Betrachter verbirgt, so dass sich ein homogener Farbeindruck des Photovoltaikmoduls 5 ergibt.

Fig. 20 zeigt eine dritte Ausführungsform eines erfindungsgemäßen Photovoltaikmoduls im Schnitt. Gleiche Bezugszeichen bezeichnen gleiche Bestandteile der Erfindung, so dass sich die Beschreibung auf die wesentlichen Unterschiede beschränkt. Das Photovoltaikmodul gemäß Fig. 20 unterscheidet sich von der ersten Ausführungsform gemäß Fig. 19 darin, dass die Rückseitenabdeckung 52 transparent ausgestaltet ist und ein Dekorelement 55 hinter der Rückseitenabdeckung 52 angeordnet ist. Das Dekorelement 55 kann beidseitig eine dekorative Gestaltung aufweisen, beispielsweise in Form eines Fotos, eines geometrischen Musters, einer Natursteinoptik oder einer monochromen Farbgestaltung. Die der Rückseitenabdeckung 52 zugewandte Seite des Dekorelements 55 ist in den Zwischenräumen zwischen den Halbleitersubstraten 10 sichtbar, so dass eine große Freiheit bei der Fassadengestaltung eines Gebäudes besteht. Sofern auch die der Rückseitenabdeckung 52 abgewandte Seite des Dekorelements 55 bei normalem Betrieb des Photovoltaikmoduls 5 sichtbar ist, so kann diese eine abweichende Gestaltung aufweisen, so dass sich dem Benutzer von beiden Seiten ein dekorativer Anblick des Photovoltaikmoduls 5 bietet.

In einigen Ausführungsformen der Erfindung kann das Dekorelement 55 leicht auswechselbar gestaltet sein, beispielsweise als Selbstklebefolie oder durch Klettverschlüsse. Hierdurch kann das Aussehen des Photovoltaikmodul 5 an wechselnde Erfordernisse angepasst werden.

Fig. 21 zeigt eine vierte Ausführungsform eines erfindungsgemäßen Photovoltaikmoduls im Schnitt. Von der vorstehend beschriebenen dritten Ausführungsform unterscheidet sich die Ausführungsform gemäß Fig. 21 dadurch, dass das Dekorelement 55 in einer weiteren Einbettungsfolie 32 aufgenommen ist. Hierdurch ist das Dekorelement 55 vor Beschädigung durch mechanische Einwirkung oder Feuchtigkeit geschützt und das Photovoltaikmodul 5 weist einen besonders robusten Aufbau auf.

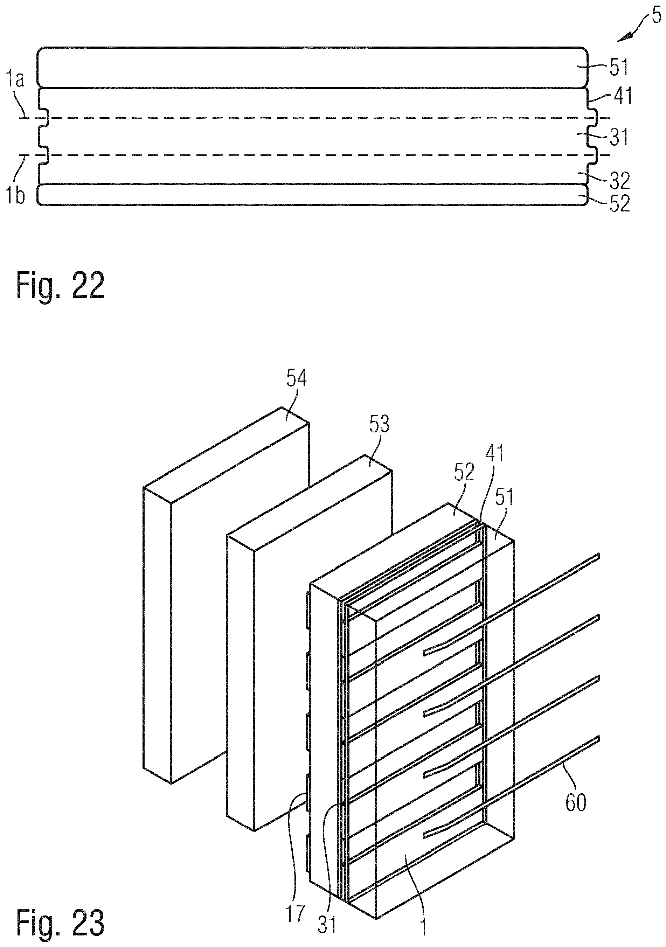

Fig. 22 zeigt eine fünfte Ausführungsform eines erfindungsgemäßen Photovoltaikmoduls im Schnitt. Die fünfte Ausführungsform unterscheidet sich von der ersten Ausführungsform dadurch, dass photovoltaische Zellen 1a in einer ersten Ebene angeordnet sind und photovoltaische Zellen 1b in einer zweiten Ebene angeordnet sind, wobei die zweite Ebene in Lichteinfallsrichtung hinter der ersten Ebene angeordnet ist. Zwischen den photovoltaischen Zellen 1a der ersten Ebene und den photovoltaischen Zellen 1b der zweiten Ebene befindet sich eine hintere Einbettungsfolie 31. Zwischen den photovoltaischen Zellen 1b der zweiten Ebene und dem Rückseitenabschluss 52 befindet sich eine weitere Einbettungsfolie 32.

Die photovoltaischen Zellen 1a und 1b können im Streifenmuster im Photovoltaikmodul 5 angeordnet sein. Hierdurch ergibt sich eine winkelabhängige Absorption von Sonnenlicht und ein ebenfalls winkelabhängiger Ausblick durch ein mit dem Photovoltaikmodul 5 versehenes Fenster. Beispielsweise kann bei nahezu horizontaler Blickrichtung der Ausblick nur gering beeinträchtigt sein, wohingegen Sonnenlicht, welches aus einer erhöhten Position auf das Photovoltaikmodul 5 fällt, in beiden Ebenen absorbiert wird, da Licht, welches durch die Zwischenräume zwischen den photovoltaischen Zellen 1a fällt von den photovoltaischen Zellen 1b absorbiert und zur elektrischen Energieerzeugung genutzt wird. In einigen Ausführungsformen können die photovoltaischen Zellen 1a an einen ersten Wechselrichter angeschlossen sein und die photovoltaischen Zellen 1b können an einen zweiten Wechselrichter angeschlossen sein.

Fig. 23 zeigt eine sechste Ausführungsform eines erfindungsgemäßen Photovoltaikmoduls. Die sechste Ausführungsform unterscheidet sich von der fünften Ausführungsform dadurch, dass anstelle der photovoltaischen Zellen 1b der zweiten Ebene bewegliche oder starre Lamellen 17 vorhanden sind, mit welchen der Lichteintritt in einen hinter dem Photovoltaikmodul 5 liegenden Raum und der Ausblick aus diesem Raum gesteuert werden kann. In einigen Ausführungsformen können die Lamellen 17 in Form einer opaken Klebefolie oder Beschichtung auf der Verglasung 52 aufgebracht sein. Fig. 23 erläutert weiterhin, wie das Photovoltaikmodul 5 Teil einer Zwei- oder Dreifachverglasung sein kann, welche aus den Glaselementen 53 und 54 besteht, wobei als äußerste Verglasung das Photovoltaikmodul 5 dient.

Fig. 23 zeigt weiterhin, wie schräg einfallendes Sonnenlicht 60 von den photovoltaischen Zellen 1 absorbiert wird. Licht, welches durch die Zwischenräume in den Innenraum des Gebäudes dringt, kann durch die Lamellen 17 absorbiert werden.

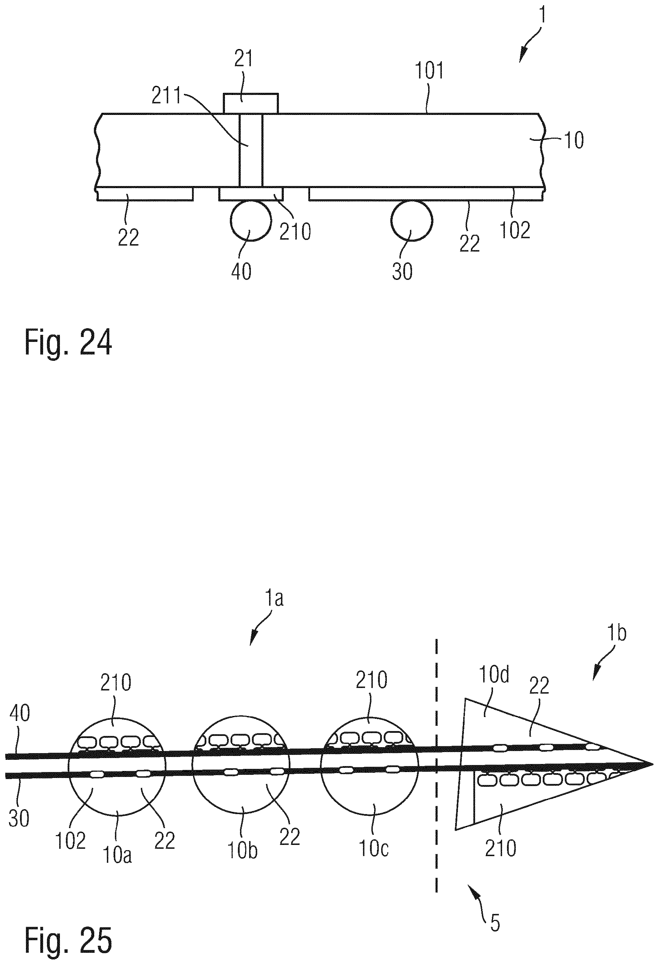

Fig. 24 zeigt eine alternative Ausführungsform von Halbleitersubstraten im Schnitt. Das Halbleitersubstrat 10 gemäß Fig. 24 weist eine Vorderseite 101 und eine Rückseite 102 auf, wie vorstehend beschrieben. Auf der Vorderseite 101 sind Vorderseitenkontakte 21 angeordnet. Dementsprechend sind auf der Rückseite 102 Rückseitenkontakte 22 angeordnet. Sonnenlicht tritt über die Vorderseite 101 in das Halbleitersubstrat 10 und wird dort absorbiert, wobei sich Elektronen-Loch-Paare bilden, welche als elektrische Spannung und elektrischer Strom zwischen Vorderseitenkontakt 21 und Rückseitenkontakt 22 abgegriffen werden können.

Um die Abschattung der Vorderseite 101 durch Stromschienen zu vermeiden oder zumindest zu reduzieren, befindet sich unter dem Vorderseitenkontakt 21 eine Bohrung 211, welche mit einem leitfähigem Material gefüllt ist oder leitfähig beschichtet ist, so dass der Vorderseitenkontakt 21 mit einem Kontaktelement 210 auf der Rückseite 102 des Halbleitersubstrates 10 verbunden werden kann. Das Kontaktelement 210 kann mit der Stromschiene 40 verbunden werden, so dass beide Stromschienen 30 und 40 auf der Rückseite 102 des Halbleitersubstrates 10 bzw. der photovoltaischen Zelle 1 angeordnet sind.

Fig. 25 zeigt eine siebte Ausführungsform eines erfindungsgemäßen Photovoltaikmoduls. Die siebte Ausführungsform verwendet Halbleitersubstrate gemäß Fig. 24, so dass die erste Stromschiene und die zweite Stromschiene 30 beide auf der Unterseite 102 der Halbleitersubstrate 10 angeordnet sind. Dargestellt sind wiederum zwei photovoltaische Zellen 1a und 1b, wobei das Photovoltaikmodul 5 selbstverständlich auch eine größere Anzahl von photovoltaischen Zellen und eine größere Anzahl von Stromschienen aufweisen kann.

Die erste photovoltaische Zelle weist drei Halbleitersubstrate 10a, 10b und 10c auf, welche jeweils eine in etwa runde Grundform aufweisen. Die Kontaktelemente 210 und die Rückseitenkontakte 22 sind so angeordnet, dass die Kontaktelemente 210 von der ersten Stromschiene 40 kontaktiert werden und die Rückseitenkontakte 22 von der zweiten Stromschiene 30 kontaktiert werden. Hierdurch ergibt sich eine elektrische Parallelschaltung der drei Halbleitersubstrate 10a, 10b und 10c in der photovoltaischen Zelle 1a.

Die zweite photovoltaische Zelle 1b weist ein einziges Halbleitersubstrat 10d. In anderen Ausführungsformen der Erfindung kann die Anzahl der Halbleitersubstrate in den jeweiligen Zellen größer oder geringer sein. Vorteilhaft weist jedoch jede photovoltaische Zelle in etwa die gleiche Fläche von Halbleitersubstraten auf, so dass die von der photovoltaischen Zelle gelieferte Spannung und Stromstärke in etwa gleich sind. Selbstverständlich kann, wie bereits vorstehend beschrieben, die jeweilige Form der Halbleitersubstrate 10 unterschiedlich sein.

Wie aus Fig. 25 ersichtlich ist, ist das Halbleitersubstrat 10g so angeordnet, dass das Kontaktelement 210 mit der zweiten Stromschiene 30 kontaktiert wird und der Rückseitenkontakt 22 mit der ersten Stromschiene 40 kontaktiert ist. Auf diese Weise ergibt sich eine Serienschaltung der ersten photovoltaischen Zelle 1a und der zweiten photovoltaischen Zelle 1b.

Selbstverständlich ist die Erfindung nicht auf die in den Figuren dargestellten Ausführungsformen beschränkt. Die vorstehende Beschreibung ist nicht als beschränkend, sondern als erläuternd anzusehen. Merkmale aus unterschiedlichen, vorstehend detailliert beschriebenen Ausführungsformen der Erfindung können zu weiteren Ausführungsformen kombiniert werden. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Merkmale definieren, so dient diese Bezeichnung der Unterscheidung zweier gleichartiger Merkmale, ohne eine Rangfolge festzulegen.

## Patentansprüche

1. Photovoltaikmodul (5) mit einer Mehrzahl photovoltaischer Zellen (1), jeweils enthaltend eine Mehrzahl flächig ausgebildeter Halbleitersubstrate (10) mit jeweils einer Vorderseite (101) und jeweils einer Rückseite (102), wobei auf der Vorderseite (101) zumindest ein Vorderseitenkontakt (21) angeordnet ist und auf der Rückseite (102) zumindest ein Rückseitenkontakt (22) angeordnet ist, wobei die Halbleitersubstrate (10) jeweils eine Teilfläche der photovoltaischen Zelle (1) bilden und elektrisch parallel miteinander verschaltet sind, wobei die Halbleitersubstrate (10) beabstandet zueinander angeordnet sind, so dass Licht zwischen den Halbleitersubstraten (10) hindurchtreten kann, und wobei zumindest zwei Halbleitersubstrate (10) aus der Mehrzahl flächig ausgebildeter Halbleitersubstrate (10) einer photovoltaischen Zelle (1) eine unterschiedliche Form und/oder Größe aufweisen und die Mehrzahl flächig ausgebildeter Halbleitersubstrate (10) jeder photovoltaischen Zelle (1) den gleichen Flächeninhalt aufweist und die Mehrzahl flächig ausgebildeter Halbleitersubstrate (10) in einem nicht periodischen Muster angeordnet ist.

2. Photovoltaikmodul nach Anspruch 1, **dadurch gekennzeichnet, dass** die photovoltaische Zelle (1) eine Mehrzahl (3, 4) von Stromschienen (30, 40) aufweist, deren Längserstreckungen entlang einer ersten Raumrichtung verlaufen und welche mit der Längserstreckung der Vorderseitenkontakte (21) einen Winkel von etwa 20° bis etwa 90° oder einen Winkel von etwa 45° bis etwa 90° oder einen Winkel von etwa 80° bis etwa 90° einschließen.

3. Photovoltaikmodul nach Anspruch 2, **dadurch gekennzeichnet, dass** jede Stromschiene (30, 40) über zumindest einen Vorderseitenkontakt (21) oder zumindest einen Rückseitenkontakt (22) mit jeder anderen Stromschiene (30, 40) elektrisch verbunden ist.

4. Photovoltaikmodul nach einem der Ansprüche 1 bis 3, **dadurch gekennzeichnet, dass** die Vorderseitenkontakte über Durchführungen (103) in den Halbleitersubstraten (10) auf die Rückseite (102) des Halbleitersubstrates (10) geführt sind.

5. Photovoltaikmodul nach einem der Ansprüche 1 bis 4, **dadurch gekennzeichnet, dass** jede Stromschiene (30, 40) mit Ausnahme zumindest einer einer randständigen Stromschiene mit zumindest zwei Vorderseitenkontakten (21) oder zwei Rückseitenkontakten (22) unterschiedlicher Halbleitersubstrate (10) verbunden ist.

6. Photovoltaikmodul nach einem der Ansprüche 1 bis 5, **dadurch gekennzeichnet, dass** die photovoltaische Zelle (1) erste Stromschienen (4) aufweist, welche mit den Vorderseitenkontakten (21) verbunden sind und zweite Stromschienen (3) aufweist, welche mit den Rückseitenkontakten (22) verbunden sind.

7. Photovoltaikmodul nach Anspruch 6, **dadurch gekennzeichnet, dass** die ersten Stromschienen (4) und die zweiten Stromschienen (3) in etwa parallel zueinander angeordnet sind, wobei die ersten und die zweiten Stromschienen (3, 4) in einer Richtung orthogonal zur Längserstreckung der Stromschienen (3, 4) zueinander versetzt sind.

8. Photovoltaikmodul nach einem der Ansprüche 1 bis 7, **dadurch gekennzeichnet, dass** die Mehrzahl flächig ausgebildeter Halbleitersubstrate (10) aus dem gleichen oder demselben Material bestehen.

9. Photovoltaikmodul nach einem der Ansprüche 1 bis 7, **dadurch gekennzeichnet, dass** die Mehrzahl flächig ausgebildeter Halbleitersubstrate (10) aus dem gleichen oder demselben Material bestehen und zumindest zwei Halbleitersubstrate (10) eine Beschichtung unterschiedlicher Farbe aufweisen.

10. Photovoltaikmodul nach einem der Ansprüche 1 bis 8, weiterhin enthaltend Teilstücke (15), welche nicht elektrisch mit den Stromschienen (3, 4) verbunden sind und/oder weiterhin enthaltend Teilstücke (16), welche aus einem isolierenden Material gefertigt sind und zumindest einen Vorderseitenkontakt (21) und/oder zumindest einen Rückseitenkontakt (22) aufweisen, welcher elektrisch mit zumindest zwei Stromschienen (3, 4) verbunden ist.

11. Photovoltaikmodul nach einem der Ansprüche 1 bis 10, **dadurch gekennzeichnet, dass** die photovoltaischen Zellen (1) seriell miteinander verschaltet sind.

12. Photovoltaikmodul nach einem der Ansprüche 1 bis 11, **dadurch gekennzeichnet, dass** die photovoltaischen Zellen (1a, 1b) in einer ersten Ebene und in einer zweiten Ebene angeordnet sind, wobei die zweite Ebene in Lichteinfallsrichtung hinter der ersten Ebene angeordnet ist.

13. Gebäude (6) oder Fassadenelement (61) oder Fensterelement (62) mit einem Photovoltaikmodul nach einem der Ansprüche 1 bis 12.

## Claims

1. Photovoltaic module (5) comprising a plurality of photovoltaic cells (1), each containing a plurality of flat semiconductor substrates (10), each having a front face (101) and a rear face (102), wherein at least one front face contact (21) is arranged on the front face (101) and at least one rear face contact (22) is arranged on the rear face (102), wherein the semiconductor substrates (10) each form a subarea of the photovoltaic cell (1) and are electrically connected to one another in parallel, wherein the semiconductor substrates (10) are arranged at a distance from one another so that light can penetrate between the semiconductor substrates (10) and wherein at least two semiconductor substrates (10) from the plurality of flat semiconductor substrates (10) of a photovoltaic cell (1) have a different shape and/or size and the plurality of flat semiconductor substrates (10) of each photovoltaic cell (1) has the same surface area and the plurality of flat semiconductor substrates (10) is arranged in a non-periodic pattern.

2. Photovoltaic module according to claim 1, **characterized in that** the photovoltaic cell (1) has a plurality (3, 4) of power rails (30, 40), the longitudinal extensions of which extend along a first spatial direction and which enclose with the longitudinal extension of the front face contacts (21) an angle of about 20° to about 90° or an angle of about 45° to about 90° or an angle of about 80° to about 90°.

3. Photovoltaic module according to claim 2, **characterized in that** each power rail (30, 40) is electrically connected to every other power rail (30, 40) via at least one front face contact (21) or at least one rear face contact (22).

4. Photovoltaic module according to any of claims 1 to 3, **characterized in that** the front face contacts are guided to the rear face (102) of the semiconductor substrate (10) via passages (103) in the semiconductor substrates (10).

5. Photovoltaic module according to any of claims 1 to 4, **characterized in that** each power rail (30, 40) with the exception of at least one peripheral power rail is connected to at least two front face contacts (21) or two rear face contacts (22) of different semiconductor substrates (10).

6. Photovoltaic module according to any of claims 1 to 5, **characterized in that** the photovoltaic cell (1) has first power rails (4), which are connected to the front face contacts (21) and has second power rails (3), which are connected to the rear face contacts (22).

7. Photovoltaic module according to claim 6, **characterized in that** the first power rails (4) and the second power rails (3) are arranged approximately parallel to one another, wherein the first and second power rails (3, 4) are offset to one another in a direction orthogonal to the longitudinal extension of the power rails (3, 4).

8. Photovoltaic module according to any of claims 1 to 7, **characterized in that** the plurality of flat semiconductor substrates (10) consists of an equal or the same material.

9. Photovoltaic module according to any of claims 1 to 7, **characterized in that** the plurality of flat semiconductor substrates (10) consists of an equal or the same material and at least two semiconductor substrates (10) have a coating of different color.

10. Photovoltaic module according to any of claims 1 to 8, further comprising segments (15), which are not electrically connected to the power rails (3, 4), and/or further comprising segments (16), which are made from an insulating material and have at least one front face contact (21) and/or at least one rear face contact (22), which is electrically connected to at least two power rails (3, 4).

11. Photovoltaic module according to any of claims 1 to 10, **characterized in that** the photovoltaic cells (1) are serially connected to one another.

12. Photovoltaic module according to any of claims 1 to 11, **characterized in that** the photovoltaic cells (1a, 1b) are arranged in a first plane and in a second plane, the second plane being arranged behind the first plane in the direction of the incident light.

13. Building (6) or a façade element (61) or a window element (62) comprising a photovoltaic module according to any of claims 1 to 12.

## Revendications

1. Module photovoltaïque (5) comportant une pluralité de cellules photovoltaïques (1) comprenant chacune une pluralité de substrats semi-conducteurs (10) de forme plate ayant chacun une face avant (101) et une face arrière (102),
dans lequel
au moins un contact de face avant (21) est disposé sur la face avant (101) et au moins un contact de face arrière (22) est disposé sur la face arrière (102),
les substrats semi-conducteurs (10) forment chacun une surface partielle de la cellule photovoltaïque (1) et sont connectés électriquement en parallèle les uns aux autres,
les substrats semi-conducteurs (10) sont disposés à distance les uns des autres de telle sorte qu'une lumière peut passer entre les substrats semi-conducteurs (10), et
au moins deux substrats semi-conducteurs (10) de la pluralité de substrats semi-conducteurs (10) de forme plate d'une cellule photovoltaïque (1) présentent une forme et/ou une taille différente, et la pluralité de substrats semi-conducteurs (10) de forme plate de chaque cellule photovoltaïque (1) présentent la même superficie, et la pluralité de substrats semi-conducteurs (10) de forme plate sont disposés selon un motif non périodique.

2. Module photovoltaïque selon la revendication 1,
**caractérisé en ce que** la cellule photovoltaïque (1) comprend une pluralité (3, 4) de barres conductrices (30, 40) dont les extensions longitudinales s'étendent le long d'une première direction spatiale et qui forment avec l'extension longitudinale des contacts de face avant (21) un angle d'environ 20° à environ 90° ou un angle d'environ 45° à environ 90° ou un angle d'environ 80° à environ 90°.

3. Module photovoltaïque selon la revendication 2,
**caractérisé en ce que** chaque barre conductrice (30, 40) est reliée électriquement à chaque autre barre conductrice (30, 40) par au moins un contact de face avant (21) ou par au moins un contact de face arrière (22).

4. Module photovoltaïque selon l'une des revendications 1 à 3,
**caractérisé en ce que** les contacts de face avant sont amenés sur la face arrière (102) du substrat semi-conducteur (10) par des traversées (103) dans les substrats semi-conducteurs (10).

5. Module photovoltaïque selon l'une des revendications 1 à 4,
**caractérisé en ce que** chaque barre conductrice (30, 40), à l'exception d'au moins une barre conductrice côté bord, est reliée à au moins deux contacts de face avant (21) ou deux contacts de face arrière (22) de substrats semi-conducteurs (10) différents.

6. Module photovoltaïque selon l'une des revendications 1 à 5,
**caractérisé en ce que** la cellule photovoltaïque (1) comprend des premières barres conductrices (4) reliées aux contacts de face avant (21) et des deuxièmes barres conductrices (3) reliées aux contacts de face arrière (22).

7. Module photovoltaïque selon la revendication 6,
**caractérisé en ce que** les premières barres conductrices (4) et les deuxièmes barres conductrices (3) sont disposées sensiblement parallèlement les unes aux autres, les premières et les deuxièmes barres conductrices (3, 4) étant décalées les unes par rapport aux autres dans une direction orthogonale à l'extension longitudinale des barres conductrices (3, 4).

8. Module photovoltaïque selon l'une des revendications 1 à 7,
**caractérisé en ce que** la pluralité de substrats semi-conducteurs (10) de forme plate sont constitués d'un matériau identique ou du même matériau.

9. Module photovoltaïque selon l'une des revendications 1 à 7,
**caractérisé en ce que** la pluralité de substrats semi-conducteurs (10) de forme plate sont constitués d'un matériau identique ou du même matériau, et au moins deux substrats semi-conducteurs (10) présentent un revêtement de couleur différente.

10. Module photovoltaïque selon l'une des revendications 1 à 8, comprenant en outre des portions (15) qui ne sont pas reliées électriquement aux barres conductrices (3, 4), et/ou
comprenant en outre des portions (16) qui sont fabriquées en un matériau isolant et qui présentent au moins un contact de face avant (21) et/ou au moins un contact de face arrière (22) qui est relié électriquement à au moins deux barres conductrices (3, 4).

11. Module photovoltaïque selon l'une des revendications 1 à 10, **caractérisé en ce que** les cellules photovoltaïques (1) sont connectées en série les unes aux autres.

12. Module photovoltaïque selon l'une des revendications 1 à 11, **caractérisé en ce que** les cellules photovoltaïques (1a, 1b) sont disposées dans un premier plan et dans un deuxième plan, le deuxième plan étant disposé en aval du premier plan dans le sens d'incidence de la lumière.

13. Bâtiment (6) ou élément de façade (61) ou élément de fenêtre (62), comprenant un module photovoltaïque selon l'une des revendications 1 à 12.
